# EUROPEAN PATENT APPLICATION

(11) **EP 2 096 192 A1**
(43) Date of publication of application: **02.09.2009**
(21) Application number: 08160908.3
(22) Date of filing: 22.07.2008
(51) Int. Cl.: C23C 16/455, C23C 14/56

(54) **Backside coating prevention device.**

(30) Priority: 29.05.2008 US 128856; 28.02.2008 EP 08152074; 29.05.2008 EP 08009828
(71) Applicant: Applied Materials, Inc., Santa Clara, CA 95054 (US)
(72) Inventor: Sauer, Andreas, 65762, Großostheim (DE); Henrich, Jürgen, 63694, Limeshain (DE); Gebele, Thomas, 63579, Freigericht (DE)
(74) Representative: Zimmermann & Partner

(57) **Abstract**

A backside coating prevention device adapted for a coating chamber for coating plate-shaped substrates (100) is provided, said coating chamber being adapted for coating continuously or discontinuously transported plate-shaped substrates, comprising a front wall having a substrate feeding opening (20) and a rear wall having a substrate discharge opening (22), a coating material source (26) adapted for dispensing coating material into the coating chamber, and a transport system (32,33), a front side of the transport system facing the coating material source, the transport system being adapted for continuously or discontinuously transporting a plurality of plate-shaped substrates along a transport path on the front side of the transport system, wherein said backside coating prevention device is adapted for providing a gas barrier at the front side of the transport system and adjacent to the backsides of the plurality of plate-shapes substrates for preventing backside coating of the plate-shaped substrates.

## Description

### TECHNICAL FIELD OF THE INVENTION

The present invention relates to a backside coating prevention device, a coating chamber, and a method of coating. Particularly, the present invention relates to a backside coating prevention device adapted for a coating chamber for coating plate-shaped substrates, a coating chamber for coating plate-shaped substrates, the coating chamber comprising a backside coating prevention device, and a method of coating plate-shaped substrates.

### BACKGROUND OF THE INVENTION

Thin-film coating of material on plate-shaped substrates may be accomplished in many ways, for example by evaporation or sputtering of the coating material. In some instances, for example in the manufacture of solar cells, it is desirable to coat exclusively one surface or maybe also the lateral faces of the plate-shaped substrates.

In known installations for coating continuously conveyed plate-shaped substrates, typically glass substrates, with thin layers by cathode sputtering, several compartments are located one after another. Each compartment comprises at least one sputtering cathode and process gas inlets, and is connected with a vacuum pump for evacuation. The compartments are connected to one another by means of openings, typically vacuum locks or airlocks, which may comprise one or more slit valves. A transport system comprising transport rolls for transporting the plate-shaped substrates along a path below the sputtering cathodes and passing the substrates through the openings between the compartments is provided.

When operating a sputtering cathode, a plasma is established and ions of the plasma are accelerated onto a target of coating material to be deposited onto the substrates. This bombardment of the target results in ejection of atoms of the coating material, which accumulate as a deposited film on the substrate below the sputtering cathode.

In known designs of a compartment for sputtering continuously transported rectangular plate-shaped substrates, coating material may be deposited not only on the front sides and, in some instances, on the lateral sides of the plate-shaped substrates as desired, but also on the backsides thereof, which is especially undesirable for glass substrates for solar cells.

### SUMMARY OF THE INVENTION

In one aspect it is provided a backside coating prevention device adapted for a coating chamber for coating plate-shaped substrates, said coating chamber being adapted for coating continuously or discontinuously transported plate-shaped substrates, including a front wall having a substrate feeding opening and a rear wall having a substrate discharge opening, a coating material source adapted for dispensing coating material into the coating chamber, and a transport system, a front side of the transport system facing the coating material source, the transport system being adapted for continuously or discontinuously transporting a plurality of plate-shaped substrates along a transport path on the front side of the transport system, wherein said backside coating prevention device is adapted for providing a gas barrier at the front side of the transport system and adjacent to the backsides of the plurality of plate-shapes substrates for preventing backside coating of the plate-shaped substrates.

A further aspect is directed to a coating chamber for coating plate-shaped substrates, said coating chamber being adapted for coating continuously or discontinuously transported plate-shaped substrates, including a front wall having a substrate feeding opening and a rear wall having a substrate discharge opening, a coating material source adapted for dispensing coating material into the coating chamber, and a transport system, a front side of the transport system facing the coating material source, the transport system being adapted for continuously or discontinuously transporting a plurality of plate-shaped substrates along a transport path on the front side of the transport system, wherein said backside coating prevention device is adapted for providing a gas barrier at the front side of the transport system and adjacent to the backsides of the plurality of plate-shapes substrates for preventing backside coating of the plate-shaped substrates.

According to another aspect, a method of coating plate-shaped substrates in a coating chamber includes conveying a plurality of plate-shaped substrates through the coating chamber by a) feeding one of the plate-shaped substrates into the coating chamber through a substrate feeding opening in a front wall of the coating chamber and arranging the plate-shaped substrate on a transport system for continuously or discontinuously transporting the plurality of plate-shaped substrates along a transport path on the front side of the transport system, b) continuously or discontinuously transporting the plate-shaped substrate along the transport path, while providing a gas barrier at the front side of the transport system and adjacent to the backside of the plate-shaped substrate for preventing backside coating of the plate-shaped substrate and while dispensing coating material from a coating material source provided in the coating chamber towards a front side of the plate-shaped substrate, c) discharging the plate-shaped substrate through a substrate discharge opening in a rear wall of the coating chamber, wherein the plate-shaped substrate is discharged while another one of the plate-shaped substrates is being conveyed through the coating chamber.

### BRIEF DESCRIPTION OF THE DRAWINGS

Some of the above mentioned aspects will be described in more detail in the following description of typical embodiments with reference to the following drawings in which:

Fig. 1 shows a cross-sectional view of a coating chamber including a backside coating prevention device according to embodiments described herein.

Fig. 2 is a cross-sectional view of the coating chamber along line A-A shown in Fig. 1, including a schematic illustration of a part of the backside costing prevention device outside the coating chamber according to embodiments described herein.

Fig. 3 is a top view on a section of a transport system of the coating chamber shown in Fig. 1 and 2.

Fig. 4 is a flow diagram of a coating method according to embodiments described herein.

Fig. 5 is a flow diagram of another coating method according to embodiments described herein.

Fig. 6 is a flow diagram of a further coating method according to embodiments described herein.

Fig. 7 shows a top view on a section of a transport system of another coating chamber according to embodiments described herein.

Fig. 8 is a top view on a section of a transport system of another coating chamber according to embodiments described herein.

Fig. 9 shows a top view on a section of a transport system of another coating chamber according to embodiments described herein.

Fig. 10 illustrates a part of another variation of a backside coating prevention device according to embodiments described herein.

Fig. 11 shows a part of a further variation of a backside coating prevention device according to embodiments described herein.

Fig. 12 shows a part of a yet further variation of a backside coating prevention device according to embodiments described herein.

Fig. 13 shows a part of another variation of a backside coating prevention device according to embodiments described herein.

Fig. 14 shows a part of a further variation of a backside coating prevention device according to embodiments described herein.

Fig. 15 shows a part of a yet further variation of a backside coating prevention device according to embodiments described herein.

Fig. 16 shows a part of a yet further variation of a backside coating prevention device according to embodiments described herein.

Fig. 17 shows a part of another variation of a backside coating prevention device according to embodiments described herein.

### DETAILED DESCRIPTION OF THE EMBODIMENTS

Reference will now be made in detail to the various embodiments, one ore more examples of which are illustrated in the figures. Each example is provided by way of explanation, and is not meant as a limitation of the invention. Within the following description of the drawings, the same reference numbers refer to the same components. Generally, only the differences with respect to the individual embodiments are described.

Typically, applications of the backside coating prevention device, of the coating chamber and of the coating method of the invention are in vacuum sputtering compartments of installations for coating continuously or discontinuously conveyed plate-shaped substrates with thin films. The invention is especially useful for coating plate-shaped glass substrates with thin metal films, for example with Ag films, in the manufacture of solar cells.

Without limiting the scope of the invention, the following is directed to a backside coating prevention device in a vacuum sputtering coating chamber for thin-film Ag coating of continuously transported rectangular plate-shaped glass substrates. Embodiments of the present invention can also be applied to other coating methods, such as thin-film vapour deposition, and other coating materials than Ag, e.g. other metals or alloys. Furthermore, other substrates, such as a web or plastic films, having modified shapes may be employed. Moreover, the substrate(s) may be delivered to the coating chamber continuously or may be provided in the coating chamber in a discontinuous mode. Additionally, the coating chamber may not be limited to a vacuum chamber. Typically, the glass substrate have a thickness in the range between 2 mm and 19 mm. For example, in typical solar cell applications the glass substrates have a thickness of 2 mm to 5 mm. Furthermore, the size of the glass substrates may be up to 3 meters by 6 meters in some applications.

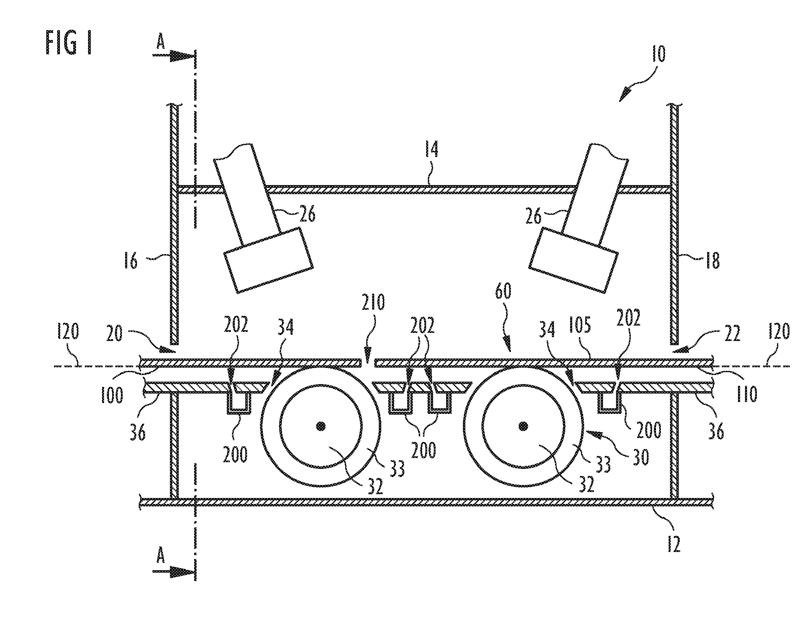

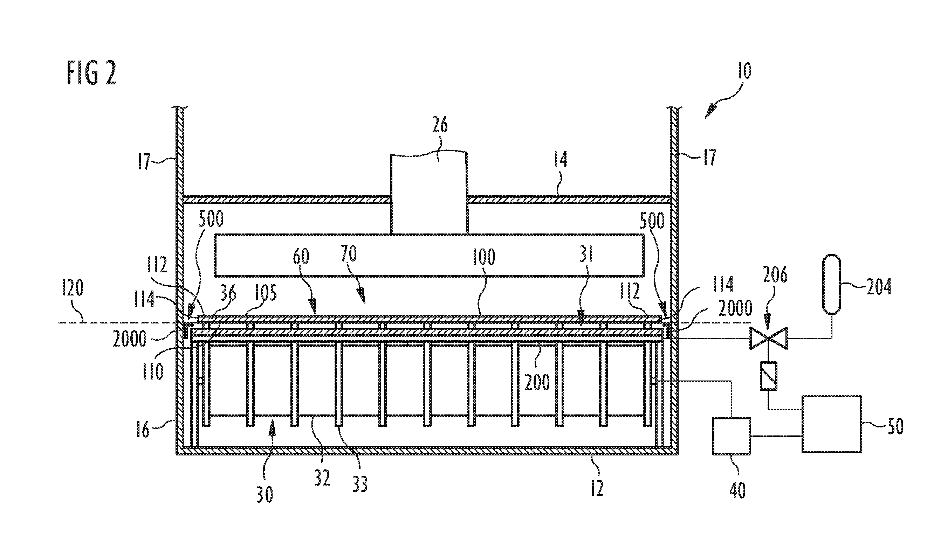

Fig. 1 illustrates a cross-sectional view of a coating chamber 10 designed as a vacuum sputtering chamber for thin-film coating of continuously transported rectangular plate-shaped glass substrates 100. The coating chamber 10 includes a backside coating prevention device 200, 202, according to embodiments described herein. Fig. 2 shows a cross-sectional view of the coating chamber 10 according to Fig. 1, along line A-A. The coating chamber 10 comprises a bottom wall 12, a top wall 14, a front wall 16, a rear wall 18 and two sidewalls 17. The material of all walls is stainless steel and the coating chamber 10 is vacuum-tight. The front wall 16 includes a substrate feeding opening 20 and the rear wall 18 includes a substrate discharge opening 22. The substrate feeding and discharge openings 20, 22 are designed as vacuum locks or airlocks, typically as slit valves, for maintaining a vacuum in the coating chamber 10 when feeding and discharging the glass substrates 100. The coating chamber 10 further has process gas inlets (not shown) and is connected to vacuum pumps (not shown) for establishing a vacuum of about 10⁻⁶ Torr. The pressure value of 10⁻⁶ Torr should, of course, be understood as an example while other pressure values or ranges are also applicable. For example, a typical pressure range for sputtering is between 10⁻³ hPa to 10⁻² hPa, a typical pressure range for evaporation is from lower than 10⁻⁶ hPa to 10⁻³ hPa, more typically in the range from 10⁻⁵ hPa to 10⁻⁴ hPa. Furthermore, at the top wall 14 one or more, typically two, sputtering cathodes 26 each comprising a target of Ag are provided as coating material source adapted for dispensing coating material into the coating chamber.

On the bottom wall 12, as a substrate support, a transport system 30 for continuously conveying a plurality of glass substrates 100 is mounted, as is shown in Fig. 1 and 2, especially in Fig. 2. The transport system 30 has a front side 31 facing the sputtering cathode 26 and is adapted for supporting on the front side 31 one or more plate-shaped glass substrates 100. The transport system 30 comprises a plurality of, typically two, rotatable rolls 32 arranged in parallel to each other throughout the coating chamber 10 successively from the front wall 16 to the rear wall 18. The rolls 32 extend from one sidewall 17 to the opposite sidewall 17. Furthermore, each roll 32 is positioned below a cover panel 36 of the transport system 30 and comprises a plurality of spaced apart rings 33 being each concentrically attached to the roll 32. The rings 33 extend through openings 34 in the cover panel 36 of the transport system 30 and support the glass substrates 100 and, thereby, define a substrate support plane 120 above the cover panel 36. The substrate support plane 120 is shown in Fig. 1 and 2 as a dashed line. Front sides 105 of the glass substrates 100 supported on the rings 33 face the sputtering cathodes 26. The cover panel 36 is disposed at a front side 31 of the transport system and has an installation height such that it is positioned typically about 2 mm to about 10 mm, more typically about 2 mm to about 5 mm, most typically at least about 2 mm beneath the substrate support plane 120. The resulting distance of at least about 2 mm between the cover panel 36 and the substrate support plane 120 or transported glass substrates 100, respectively, allows for vibrations or sagging of the glass substrates 100 during transport. At the same time contact or collisions of the glass substrates 100 with the cover panel 36 are avoided. Furthermore, the distance between cover panel 36 and substrate support plane 120 defines a space below the substrate support plane.

The rolls 32 are connected to a driving unit 40, which is connected to a control unit 50, the latter being herein also referred to as control means. Both units 40 and 50 are provided outside the coating chamber as shown schematically in Fig. 2. The transport system 30 is made for conveying the plate-shaped glass substrates 100 in a transport direction along a transport path 60. The transport path 60 is defined by the transported glass substrates 100 and is positioned on the substrate support plane 120 below the sputtering cathodes 26 and through the substrate feeding and discharge openings 20, 22 of the coating chamber 10. During coating operation, the transport direction extends from the substrate feeding opening 20 to the substrate discharge opening 22.

As shown in e.g. Fig. 2, each glass substrate 100 has one front side 105 to be coated and facing the sputtering cathodes 26 during transport of the glass substrate on the transport system 30. Each glass substrate 100 further includes a backside 110 opposite to the front side 105 and facing the transport system 30 during transport of the glass substrate thereon, and two lateral ends 112 each comprising a lateral side 114. During transport of the glass substrates 100, as illustrated in Fig. 1, gaps 210 are formed between successively transported rectangular plate-shaped glass substrates 100 on the transport system 30. The gaps 210 extend across the full width of the transport path 60. Typically, when coating a plurality of successively transported substrates, an efficient way of operating the sputtering cathodes is a continuous mode. Ag particles, which are sputtered in the present coating chamber 10 by the sputtering cathodes 26 towards the glass substrates 100, move along a straight trajectory and may also be deflected by collisions with other particles or with the walls of the coating chamber 10. A number of the Ag coating material particles which travel to the front sides 105 of the glass substrates 100 may pass the gaps 210 between successively transported rectangular plate-shaped glass substrates 100 and may undesirably be deposited on the backsides 110 of the glass substrates 100. Moreover, additional lateral gaps 500 are formed between the lateral sides 114 of successively transported rectangular plate-shaped glass substrates 100 and the sidewalls 17 of the coating chamber 10, as shown in Fig. 2. Therefore, the sputtered Ag particles may also pass the lateral gaps 500 and may be deposited on the backsides 110 of the glass substrates 100.

Therefore, as is illustrated in Fig. 1 to 3, in the coating chamber 10 a backside coating prevention device is provided, the backside coating prevention device according to embodiments described herein comprising a barrier gas supply unit. In a typical example shown in Fig. 1 to 3, the barrier gas supply unit includes a plurality of barrier gas conduits 200, a plurality of barrier gas outlets 202 and a barrier gas source 204. The barrier gas may be an inert gas, for example Ar gas of a suitable purity grade which is typically chosen to be the same purity grade as that of the sputter gasses used in the process. However, the barrier gas is not necessarily inert as also gas mixtures containing reactive gasses may be used. For example, a mixture of Ar, N₂, and O₂ may be used in a reactive process. Such mixture is not inert due to the O₂. In general, any gas not having a negative influence on the process may qualify as a barrier gas to be used in the disclosed apparatus and process. Typical but non-limiting examples of barrier gasses include inert gasses and/or gasses having high molecular weight. The barrier gas conduits 200 are attached to the backside of the cover panel 36 and extend in parallel to the rolls 32 of the transport system 30. Each roll 32 in the example shown in Fig. 1 to 3 is positioned between two barrier gas conduits 200. Each barrier gas conduit 200 is connected via a valve 206, typically a control valve, more typically a pressure control valve, to the barrier gas source 204. It will be understood by those skilled in the art that a mass flow controller (MFC) may be used as an alternative to valve 206 or in combination with valve 206. For example, a main MFC may be provided together with additional valves or MFCs at the individual inlets. The valve 206, also referred to as a barrier gas valve, and the barrier gas source 204 are provided outside the coating chamber 10. In typical designs of the backside coating prevention device according to embodiments described herein, one common valve 206 may be provided for all barrier gas conduits 200. In another typical design, each barrier gas conduit 200 may have one separate valve 206. The valve(s) 206 are typically operated electromagnetically and are controlled by control unit 50. Furthermore, each barrier gas conduit 200 is connected to one of the barrier gas outlets 202. The barrier gas outlets 202 are provided in the cover panel 36 in parallel to the rolls 32 and transverse, typically perpendicular, to the transport path 60, i.e. transverse, typically perpendicular, to the transport direction during coating operation.

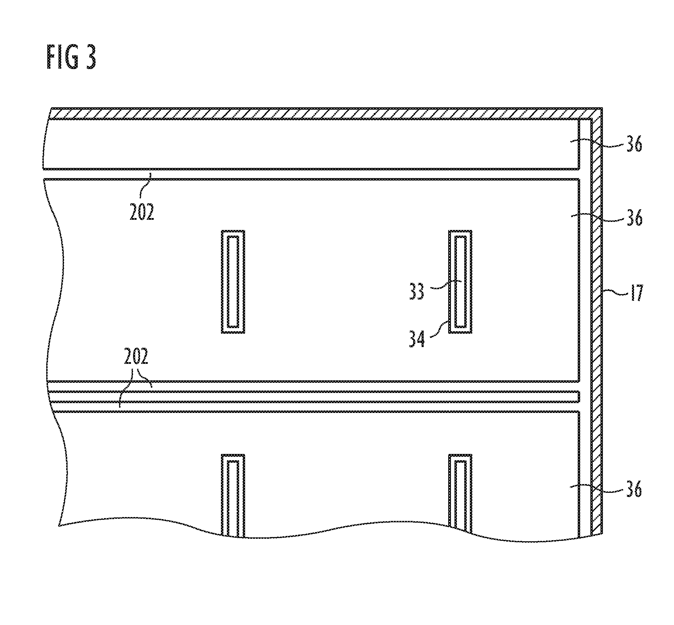

As is illustrated in the top view on the cover panel 36 according to Fig. 3, the barrier gas outlets 202 are longitudinal slits formed in the cover panel 36. The barrier gas outlets 202 are arranged in parallel to each other and extend across the full width of the cover panel 36. Furthermore, as is shown in Fig. 1, because of the installation height of the cover panel 36, the barrier gas outlets 202 are typically about 2 to about 10 mm, more typically about 2 to about 5 mm, most typically at least about 2 mm spaced apart from the substrate support plane 120, i.e. from the backsides 110 of the transported glass substrates 100.

During a typical coating operation, a plurality of rectangular plate shaped glass substrates 100 are conveyed one after another through the coating chamber 10, while the sputtering cathodes 26 are operated continuously. Each glass substrate 100 is fed into the coating chamber 10 through the substrate feeding opening 20 and arranged on the rings 33 of the transport system 30. After that, each glass substrate 100 is continuously transported by the transport system 30 along the transport path 60 below the operating sputtering cathodes 26. Finally, each glass substrate 100 is discharged through the substrate discharge opening 22. Since a plurality of glass substrates 100 is to be coated and in order to improve the effectiveness of the coating processing, two or more glass substrates 100 may simultaneously be transported on the transport system 30 in the coating chamber 10 one after another. Therefore, each time two rectangular plate shaped glass substrates 100 are successively transported through the coating chamber 10, one of the gaps 210 is formed between the two glass substrates 100. This gap 210 is moving along the transport path 60 during transport of the glass substrates 100.

According to typical embodiments of the coating method described herein, a gas barrier is provided at the front side of the transport system and adjacent to the backsides of the plate-shaped substrates for preventing backside coating of the plate-shaped substrate. More typically, a gas barrier may be provided between the front side of the transport system and the plate-shaped substrates for preventing backside coating of the plate-shaped substrates. In one example, an Ar gas barrier is established in the coating chamber 10 beneath the glass substrates 100, i.e. in the space defined between the cover panel 36 and the backsides 110 of the glass substrates 100, and also in the gaps 210, which are formed between successively transported rectangular plate-shaped glass substrates 100. Particles of Ag coating material are ejected from the sputtering cathodes 26 towards the glass substrates 100 and also towards the gaps 210 between successive glass substrates 100. Because of the Ar gas barrier, passage of Ag particles through the gaps 210 between successively transported glass substrates 100 towards the backsides 110 of the glass substrates 100 is reduced or substantially inhibited. Furthermore, the Ar gas barrier also extends through the lateral gaps 500 formed between the lateral ends 114 of the glass substrates 100 and the sidewalls 17 of the coating chamber 10. Therefore, also Ag particles traveling to the lateral gaps 500 between the glass substrates 100 and the sidewalls 17 are prevented to pass these lateral gaps 500 and to deposit on the backsides 110 of the glass substrates 100. In summary, the Ar gas barrier established by the backside coating prevention device according to embodiments described herein at least reduces or even prevents that Ag target material sputtered towards the glass substrates 100 enters the region below the glass substrates 100 via the gaps formed around the glass substrates 100.

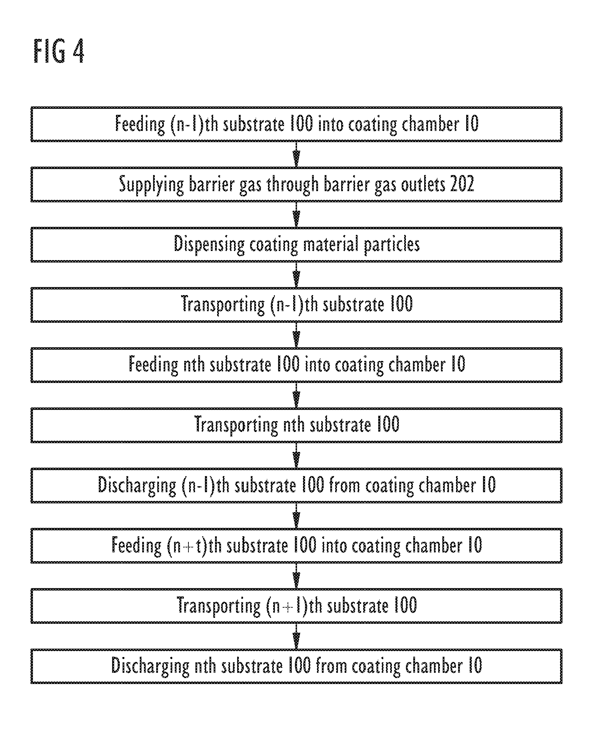

The following is an example of a coating method according to embodiments described herein, the beginning of which is shown schematically in Fig. 4. As soon as a front end of a first glass substrate 100 ((n-1)th glass substrate; n being an integer ≥ 2) has entered the coating chamber 10, control unit 50 switches on a constant Ar barrier gas flow. This barrier gas flow is established from the barrier gas source 204 through the barrier gas conduits 200 to the barrier gas outlets 202 by opening the corresponding barrier gas valves 206. Typically, the gas flow rate depends on the type of substrate to be processed, the type, size, and/or geometry of coating chamber 10, as well as on the size of gap 210. Exemplary flow rates are from about 20 sccm up to about 500 sccm. Typically, the barrier gas flow is adjusted so that the maximum amount of barrier gas in the chamber will be of the same order of magnitude as the process gas. The sputtering cathodes 26 are then switched on or, alternatively, are already working. The first glass substrate 100 is continuously transported below the operating sputtering cathodes 26 and through the coating chamber 10 while being coated on its front side 105 with Ag particles and supplied on its backside 110 with Ar barrier gas. After the rear end of the first glass substrate 100 has entered the coating chamber 10, the front end of a second (nth) glass substrate 100 is fed into the coating chamber 10 through the substrate feeding opening 20. The second glass substrate 100 is arranged on the rings 33 of the transport system 30 and transported thereon. The barrier gas flow through the barrier gas outlets 202 is kept constant as before. Again, the second glass substrate 100 is continuously transported below the operating sputtering cathodes 26 and through the coating chamber 10 while being coated on its front side 105 with Ag particles and supplied on its backside 110 with Ar barrier gas. During conveying of the second glass substrate 100, after a first and a second period of time, the front end and the rear end of the continuously transported first glass substrate 100 consecutively arrive at and are discharged through the discharge opening 22. The first and the second periods of time depend on the length, i.e. the distance between the front and the rear ends, of the first glass substrate 100, as the skilled person is aware. Thereafter, the front end of the second glass substrate 100 arrives at the substrate discharge opening 22 and is discharged from the coating chamber 10. Finally, after a period of time depending on the length of the second glass substrate 100, its rear end is discharged through the substrate discharge opening 22, thus completing the process of coating the second glass substrate 100.

In the course of above coating operation, because of the constant Ar barrier gas flow, a gas barrier is established beneath the first and second glass substrates 100, in the gap 210 which is formed between the first and second glass substrates 100 during transport, and in the lateral gaps 500 between the glass substrates 100 and the sidewalls 17 of the coating chamber. Therefore, passage of Ag particles through the gaps 210 and the lateral gaps 500 is reduced or substantially inhibited. Thereby, backside coating of the first and second glass substrates 100 is avoided. The method steps illustrated above for the second glass substrate 100 may be repeated with a third (n+1) and other successively transported glass substrate(s) 100, while the backsides 110 thereof are supplied with an Ar barrier gas flow, in order to coat a plurality of glass substrates 100 with thin Ag films and simultaneously reduce or prevent coating on the backsides 110 thereof.

According to the above example of a coating method, a constant Ar barrier gas flow is continuously supplied through the barrier gas outlets 202 after the first glass substrate 100 has entered the coating chamber 10 until the last glass substrate 100 has been discharged from the coating chamber 10. The control unit 50 controls the Ar barrier gas flow by opening and closing the barrier gas valves 206. In this example the control unit 50 switches the Ar barrier gas flow on at the time the front end of the first glass substrate 100 is fed into the coating chamber and switches it off at the time the rear end of the last glass substrate 100 is discharged from the coating chamber. Both switching times can be calculated by the control unit 50 based on predetermined information about the length of the glass substrates 100, about the width of the gaps 210 between successively transported glass substrates 100 and based on the transport speed which is controlled by the control unit 50. Alternatively, the switching times may be determined based on information derived from sensors connected to the control unit 50, typically movement sensors. Such sensors may, for instance, be positioned outside the coating chamber 10 at the front and rear walls 16, 18 near the substrate feeding opening 20 and substrate discharge opening 22. In this example of the coating method, instead of a plurality of barrier gas valves 206, one common barrier gas valve 206 connected to all barrier gas conduits 200 may be used.

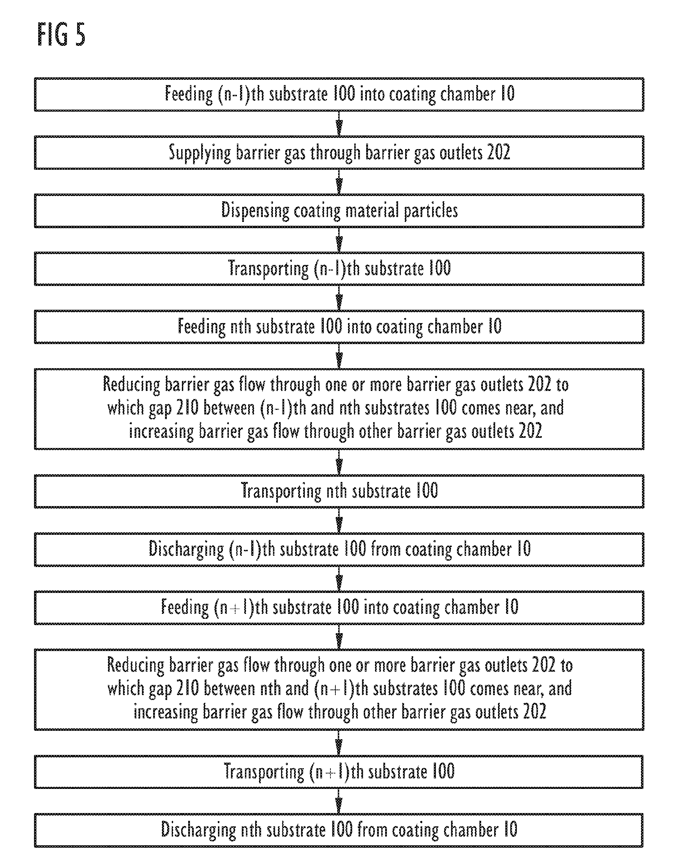

In another variation of a coating method according to embodiments described herein, the beginning of which is schematically shown in Fig. 5, the Ar barrier gas flow may be controlled during transport. This controlling of the Ar gas flow results in a variable or even discontinuous supply of the Ar barrier gas to one or more barrier gas outlets 202. In the present example, for each barrier gas conduit 200 a separate barrier gas valve 206 is provided. This means each barrier gas outlet 202 is connected via one of the barrier gas conduits 200 to the corresponding barrier gas valve 206, which is connected to the barrier gas source 204. Each time one of the gaps 210 between successively transported glass substrates 100 comes near any of the barrier gas outlets 202, the control unit 50 transmits a switching command to the barrier gas valve 206 connected to the respective barrier gas outlet 202, in order to reduce or stop the barrier gas flow. After the gap 210 has passed the barrier gas outlet 202, barrier gas flow through this barrier gas outlet is resumed by a command of the control unit 50 to the corresponding barrier gas valve 206.

Information about the length of the glass substrates 100 and the width of the gaps 210 between successively transported glass substrates 100 may be fed into the control unit 50 before starting the coating process shown in Fig. 5. Alternatively, such information may be determined during transport by corresponding sensors connected to the control unit 50. The latter also controls the driving unit 40 of the transport system 30 and, hence, the transport speed of the glass substrates 100. Therefore, the control unit 50 is able to determine the moving position of each gap 210 between successive glass substrates 100, and the barrier gas valves 206 are accordingly controlled. Thereby, in the present example shown in Fig. 5, the amount of Ar barrier gas required for backside coating prevention during coating may be reduced, since the barrier gas flow from a barrier gas outlet 202 directly through the gaps 210 between successively transported glass substrates 100 is reduced or avoided. At the same time, the barrier gas flow through the other barrier gas outlets 202 is maintained as long as they are positioned below the transported glass substrates 100. Therefore, an Ar gas barrier below the glass substrates 100 is established and maintained, the gas barrier having a gas pressure and a gas flow into the gaps 210, which are sufficient to safely avoid backside coating.

One example of typical embodiments described herein is directed to a coating method for glass substrates 100 which are shorter than the distance of the front wall 16 and the rear wall 18 of the coating chamber 10. This means that one or more gaps 210 between successively transported glass substrates 100 are arranged inside the coating chamber 10 during transport. For this case, the coating method explained above and illustrated in Fig. 5 is utilized. Again, backside coating of the glass substrates 100 is avoided while the amount of barrier gas required for backside prevention is reduced.

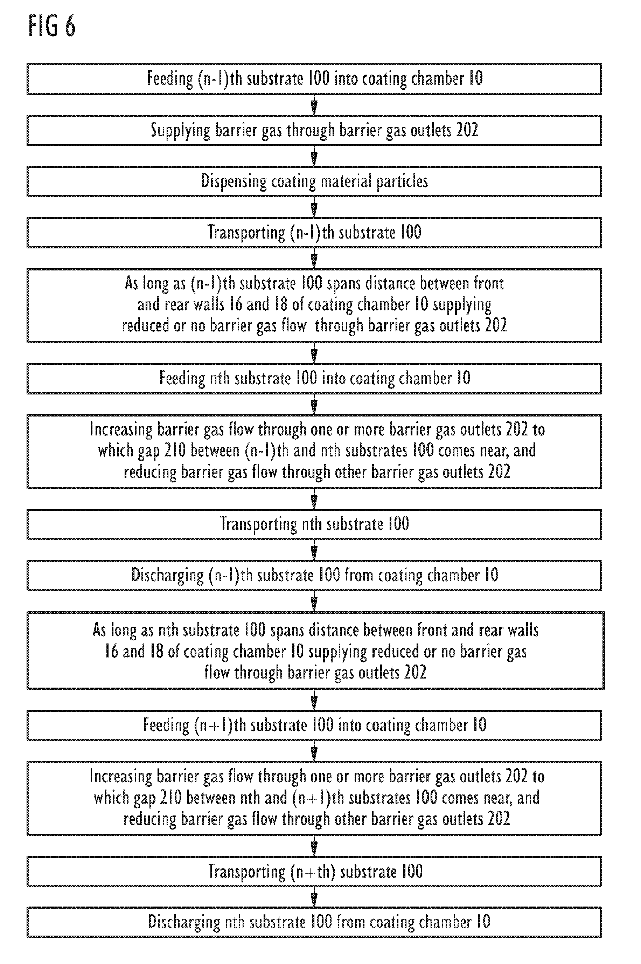

In another example of a coating method according to embodiments described herein, the beginning of which is shown schematically in Fig. 6, the glass substrates 100 are equally long or longer than the distance between the front wall 16 and the rear wall 18. Therefore, during a certain time period of transport through the coating chamber 10, each glass substrate 100 spans the distance between the front wall 16 and the rear wall 18 of the coating chamber 10, i.e. between the substrate feeding and discharge openings 20 and 22. As a result, during this time period, no gap 210 between successive glass substrates 100 is inside the coating chamber 10. Therefore, the barrier gas flow to all barrier gas outlets 202 is reduced or switched off by control unit 50 controlling the barrier gas valves 206. The time period during which no gap 210 is arranged inside the coating chamber may be determined as explained above, i.e. based on the information of the length of the glass substrates 100, of the width of the gaps 210 between successive glass substrates 100 and of the transport speed, or based on data from corresponding sensors. As soon as one of the gaps 210 between two successive glass substrates 100 enters the coating chamber 10, barrier gas flow through all barrier gas outlets 202 is started and an Ar gas barrier is established beneath the glass substrates 100. Alternatively, barrier gas may be supplied consecutively only to such barrier gas outlets 202 which are next to and/or below the moving gap 210. In another modification, only such barrier gas outlets 202 are provided with barrier gas, which are positioned before and after one of the gaps 210 moving through the coating chamber 10 and which at the same time are positioned below the successive glass substrates 100 forming this gap 210.

In case of coating glass substrates 100 having varying lengths and including glass substrates 100 which are shorter as well as glass substrates 100 which are equally long or longer than the distance between the front and the rear walls 16 and 18 of the coating chamber 10, a combination of at least parts of the methods shown in Fig. 4 or 5 and Fig. 6 may be utilized. That means, as long as no gap 210 between successively transported glass substrates 100 is arranged in the coating chamber, the Ar barrier gas flow may be reduced or switched off. As soon as one of the gaps 210 enters the coating chamber during transport of the glass substrates 100, one of the barrier gas step sequences shown in Fig. 4 and 5 is started. In each of these cases, backside coating of the glass substrates is avoided while the required amount of barrier gas is kept as small as possible.

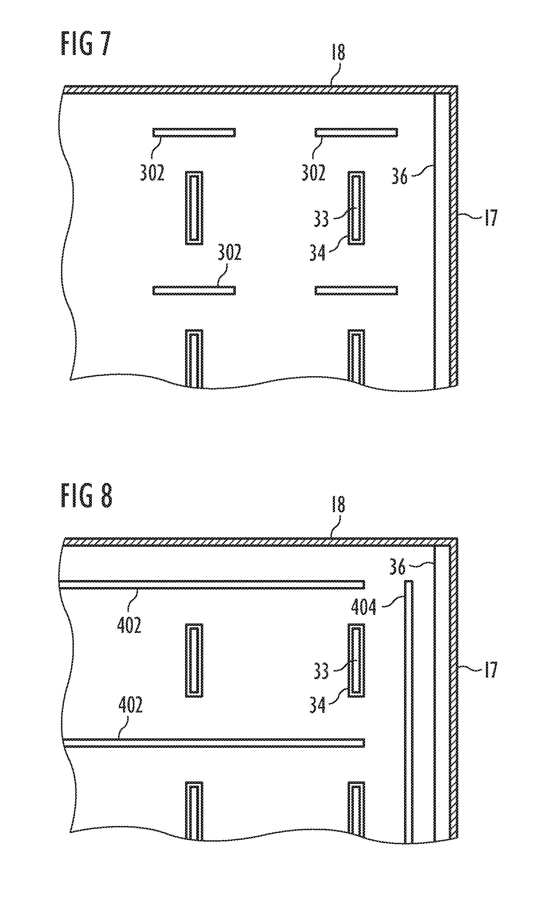

In Fig. 7 a further variation of embodiments of the backside coating prevention device described herein is shown, comprising a specific design of the barrier gas outlets provided in the cover panel 36 of the transport system 30. According to Fig. 7, instead of each of the barrier gas outlets 202 shown in Fig. 3 and extending across the full width of the cover panel 36, a plurality of barrier gas outlets 302 formed as longitudinal apertures are provided in line. In the present example, each ring 33 extending through an opening 34 of the cover panel 36 is positioned between two parallel longitudinal apertures 302. As will be understood by the person skilled in the art, in this variation of embodiments the barrier gas flow will be adjusted to the specific design of the barrier gas outlets 302. Other suitable modifications of the embodiments of the backside coating prevention device as described herein are possible, e.g. a combination of the designs of the barrier gas outlets shown in Fig. 3 and 7, as the skilled person will be aware of.

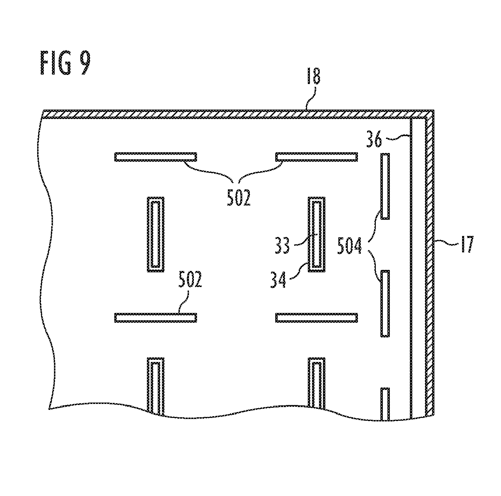

Fig. 8 and 9 illustrate other examples of typical embodiments of the backside coating prevention device. Fig. 8 shows barrier gas outlets 402 being shorter than the barrier gas outlets 202 indicated in Fig. 3, such that they do not extend across the full width of the cover panel 36. Furthermore, an additional barrier gas outlet 404 is provided in the lateral end portion of the cover panel 36, as shown in Fig. 8, in parallel to the sidewall 17, i.e. perpendicular to the barrier gas outlets 402. The opposite lateral end portion (not shown) of cover panel 36 is also provided with such an additional barrier gas outlet 404 in a mirror-inverted design. The barrier gas outlets 404 are connected to additional barrier gas conduits (not shown). In case of an embodiment having only one common barrier gas valve 206 for all barrier gas conduits as mentioned above and suitable for the method illustrated in Fig. 4, the barrier gas conduits of the barrier gas outlets 404 may also be connected to the common valve 206. Supplying barrier gas through the resulting system of barrier gas outlets 404 allows for establishing a strong Ar gas barrier in lateral gaps 500 between the transported glass substrates 100 and the sidewalls 17, thus promoting the backside coating preventing effect. Alternatively, the additional barrier gas outlets 404 may be connected to the barrier gas source 204 by additional barrier gas conduits connected to one or more additional barrier gas valves (not shown) which are separately controlled by the control unit 50. The latter example is especially suitable for a variation of the coating method including at least a part of the step sequence as illustrated in Fig. 6, i.e. in case that some or all of the glass substrates 100 are equally long or longer than the distance of the front wall 16 and the rear wall 18. This example allows for a separate supply of barrier gas to the barrier gas outlets 404 during the time period when one of the glass substrates spans the distance between the front and the rear walls 16 and 18 of the coating chamber 10 and the barrier gas flow through the barrier gas outlets 402 is reduced or stopped. Thereby, a backside coating prevention mainly with respect to the lateral gaps 500 between the glass substrates 100 and the sidewalls 17 is effected.

Fig. 9 shows a modified design of the example shown in Fig. 8, the modification being due to the fact that the barrier gas outlets 402 and 404 illustrated in Fig. 8 are split into a plurality of shorter longitudinal apertures. The backside prevention effect of the design according to Fig. 9 corresponds to the one of the example shown in Fig. 8.

Furthermore, it will be understood by those skilled in the art that in the above embodiments the coating chamber 10 will be designed for glass substrates of specific dimensions. Therefore, the dimensions of the backside coating prevention devices and the features of the corresponding coating method, e.g. the amount of the barrier gas flow, can be specifically adjusted to those dimensions of the glass substrates. Thus, by knowing the dimensions of the glass substrates for which the coating chamber and the coating method is designed, the skilled person can determine the correct dimensions of the backside coating devices and the correct features of the corresponding coating method such that a suitable gas barrier for prevention of backside coating is achieved.

In a modification of the above examples of embodiments as described herein, the barrier gas outlets may be provided in alignment with the sputtering cathodes 26. That means that some or all of the barrier gas outlets described above, typically the barrier gas outlets 202, 302, 402, 502, 504, are provided only in one or more coating regions 70 below the sputtering cathodes 26, resulting in a reduced amount of barrier gas required for backside coating prevention.

In a further variation of the embodiments of the backside coating prevention device described herein, the barrier gas conduits and barrier gas outlets may be incorporated in a cooling arrangement for cooling the glass substrates 100, thus saving space inside the coating chamber.

In another modification of the embodiments described herein, the backside coating prevention device further comprises at least two screens provided at two opposite sidewalls of the coating chamber, the sidewalls extending from the front wall to the rear wall of the coating chamber, each of the two sidewalls being provided with at least one of the screens, each screen having a protruding member protruding from the respective sidewall, each screen having the protruding member positioned so that each protruding member extends along the respective sidewall in parallel to the transport path and is spaced in the range from 1.5 mm to 5 mm from the plate-shaped substrates during coating.

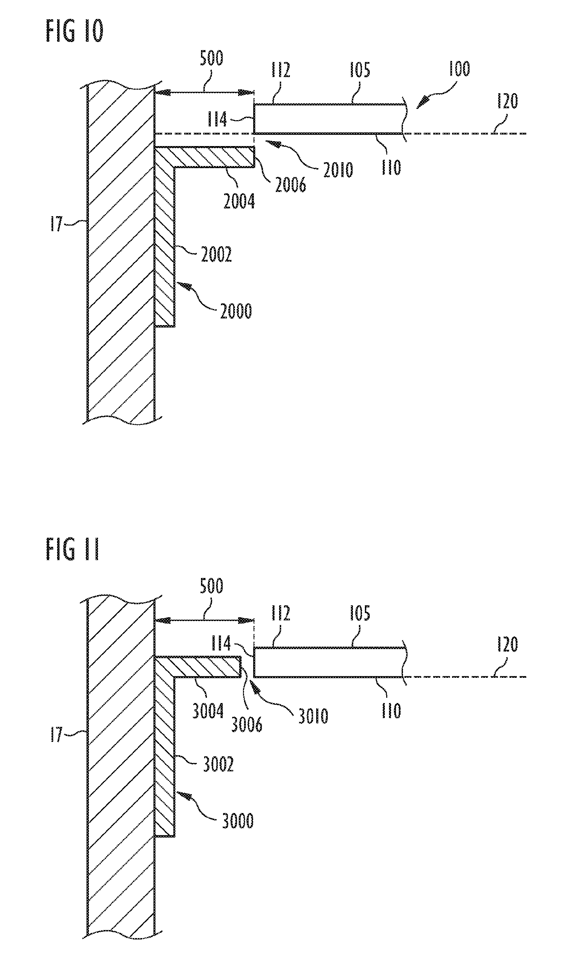

As mentioned above and shown in e.g. Fig. 10, each glass substrate 100 has the front side 105 to be coated and facing the sputtering cathodes 26 during transport of the glass substrate on the transport system 30. Moreover, each glass substrate 100 has the backside 110 opposite to the front side 105 and facing the transport system 30 during transport of the glass substrate thereon, and two lateral ends 112 each comprising one lateral side 114. It is noted that Fig. 10 only shows one of the two lateral ends 112 of glass substrate 100. It will be understood by those skilled in the art, that the arrangement shown in Fig. 10 is also provided on the opposite lateral side 114 of the glass substrate 100 but in a mirrored configuration. During transport of the glass substrates 100, as mentioned above and as is visible particularly in Fig. 10 showing only one lateral end 112 of one of the glass substrates 100, two lateral gaps 500 will be formed between the lateral sides 114 of the rectangular plate-shaped glass substrates 100 arranged on the transport system 30 and the sidewalls 17 of the compartment. The lateral gaps 500 extend along the sidewalls 17 of the coating chamber 10 in parallel to the transport direction. A number of ejected atoms of the target material may pass these lateral gaps 500 and may undesirably be deposited on the backsides 110 of the glass substrates 100.

In view of the above, in addition to the barrier gas supply unit as described above, the backside coating prevention device according to embodiments described herein may optionally include two or more screens, the screens being provided at at least two of the walls of the coating chamber 10, the screens being optionally provided below the substrate support plane. Each screen has a protruding member protruding from the respective wall. In the example of the backside coating prevention device as shown in Fig. 2, two lateral screens 2000 may optionally be included, each sidewall 17 of the coating chamber 10 being provided with one of the screens 2000 below the substrate support plane 120.

Fig. 10 illustrates an enlarged cross-sectional view of one of the screens 2000 shown in Fig. 2. Each lateral screen 2000 is made of stainless steel and typically has an L-shaped cross section, i.e. it comprises two branches 2002 and 2004 arranged perpendicularly to each other. Branch 2002 is attached to the interior side of the sidewall 17 of the coating chamber 10. Branch 2004 is provided at the top end of branch 2002 and protrudes towards the centre of the coating chamber in parallel to the substrate support plane 120, i.e. perpendicularly to the sidewall 17. Therefore, branch 2004 forms the protruding member and extends along sidewall 17 in parallel to the transport path 60. The installation height of branch 2002 at the sidewall 17 in the coating chamber 10 is such that branch 2004 is positioned about 2 to about 10 mm, typically about 2 to about 5 mm, most typically at least about 2 mm beneath the substrate support plane 120. Both branches 2002 and 2004 of the lateral screens 2000 further extend in parallel to the substrate support plane 120 along the sidewall 17 throughout the coating chamber 10, typically at least throughout a sputtering region of the coating chamber 10. That means that the sputtering cathode 26 forming the coating material source is adapted to dispense coating material at least into the coating region 70 of the coating chamber 10 and each screen 2000 is provided at least in the coating region 70.

In a typical embodiment of this variation of the backside coating prevention device, the protruding branch 2004 is positioned to be at least 2 mm spaced apart from the one or more plate-shaped substrates 100 during coating. Furthermore, branch 2004 protrudes from the sidewall 17 such that the substrate support plane 120 is positioned between the sputtering cathode 26 and branch 2004. More specifically, as mentioned above, each glass substrate 100 supported on the substrate support plane 120 has the backside 110 and two lateral ends 112 each comprising one lateral side 114. As shown in Fig. 10, a gap 2010 is formed between the backside 110 of the glass substrate 100 and the branch 2004, branch 2004 being about 2 to about 10 mm, typically about 2 to about 5 mm, most typically at least about 2 mm spaced apart from the backside 110 of the glass substrate 100, depending on the installation height of branch 2002 as explained above. Therefore, gap 2010 has a width of about 1.5 mm to about 10 mm, typically about 1.5 mm to about 5 mm, most typically at least about 2 mm. As a result of this small width, most of the Ag particles sputtered towards the lateral ends 112 of the glass substrate 100 are prevented from passing to the backside 110 thereof, since they are deposited on the upper surfaces of branches 2004 and the lateral sides 114 of the glass substrate. The gap 2010 between protruding branch 2004 and the glass substrate 100 also allows for vibrations or sagging of the glass substrate 100 during transport, preventing contact or collisions of the glass substrate 100 with the protruding branches 2004 of the backside coating prevention device.

During coating operation, glass substrates 100 are successively fed into the coating chamber 10 through the substrate feeding opening 20, continuously conveyed by the transport system 30 along the transport path 60 on the substrate support plane 120 below the operating sputtering cathode 26, and discharged through the substrate discharge opening 22. Particles of Ag coating material are ejected from the sputtering cathode 26 towards the glass substrates 100 and also laterally towards the lateral gaps 500 which are formed between the rectangular plate-shaped glass substrates 100 and the sidewalls 17 of the coating chamber 10. Coating particles ejected laterally towards these lateral gaps 500 are mainly deposited on the upper surfaces of the protruding branches 2004 of the screens 2000. Thereby, passage of Ag particles through the lateral gaps 500 between the glass substrates 100 and the sidewalls 17 towards the backside 110 of the glass substrates 100 is reduced or substantially inhibited. Moreover, in this example, coating of the lateral sides 114 of the glass substrates 100 is not prevented, as is desired for some applications of the glass substrates.

Furthermore, according to embodiments described herein, the backside coating prevention device may include screens each comprising a protruding member having a lateral end which protrudes into the coating chamber and is positioned on the substrate support plane 120. An example of this variation of embodiments is shown in Fig. 11. Like in Fig. 10, a cross-sectional view of only one screen 3000 of such a backside coating prevention device is illustrated in Fig. 11. However, typically two lateral screens 3000 are included in this example of the backside coating prevention device.

According to Fig. 11, a screen 3000 comprises a branch 3002 attached to the sidewall 17 of the coating chamber 10 and a branch 3004 formed as protruding member. Branch 3004 is mounted at the upper end of branch 3002 and protrudes into the coating chamber 10. Branch 3004 has a lateral end 3006 facing the lateral side 114 of the glass substrate 100. The installation height of branch 3004 is such that the lateral end 3006 is positioned on the substrate support plane 120. Since in this example, screen 3000 is L-shaped, i.e. branches 3002 and 3004 are arranged perpendicularly to each other, the whole branch 3004 is positioned on the substrate support plane 120. The length of branch 3004 is such that its lateral end 3006 is at least about 2 mm spaced apart, more specifically about 2 to about 10 mm, typically about 2 to about 5 mm, most typically about 2 mm spaced apart from the lateral side 114 of the glass substrate 100. As a result, only a small gap 3010 of a width of at least about 2 mm is provided between branch 3004 and the lateral side 114 of the glass substrate 100. Through this gap 3010, only a negligible amount of Ag particles ejected from the sputtering cathodes 26 towards the lateral ends 112 of the glass substrate 100 will pass.

Therefore, when using the backside coating prevention device including two screens 3000 according to the example shown in Fig. 11 during coating operation, substantially all Ag coating particles traveling towards the lateral gaps 500 between the glass substrate 100 and the sidewalls 17 are deposited on the upper surfaces of the protruding branches 3004, the lateral ends 3006 thereof and at the lateral sides 114 of the glass substrate 100. Hence, by providing the screens 3000 on both sidewalls 17 of the coating chamber, passage of Ag particles through the lateral gaps 500 between the glass substrates 100 and the sidewalls 17 towards the backside 110 of the glass substrate 100 is reduced or substantially inhibited.

Furthermore, it will be understood by those skilled in the art that in the above embodiments described with reference to Fig. 11, i.e. the embodiments showing a lateral gap 3010, the dimensions of the branches, especially of the protruding branches, will be adjusted with respect to the width of the glass substrates to be coated. In particular, it will be understood by those skilled in the art that the coating chamber 10 will be designed for glass substrates of specific dimensions so that the dimensions, especially the lengths, of the screens of the backside coating prevention devices shown in Fig. 10 and 11 can be specifically adjusted to those dimensions of the glass substrates. Thus, by knowing the dimensions of the glass substrates for which the coating chamber is designed, the skilled person can determine the correct dimension of the screens of the embodiments of Fig. 10 and 11, so that a specific gap width between the screens and the glass substrates is achieved in the coating chamber during operation.

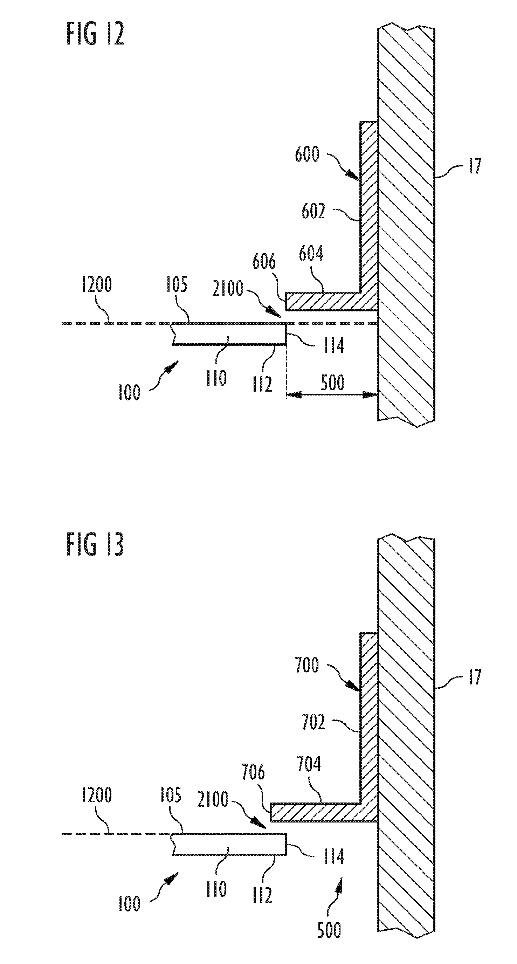

As mentioned above, and as shown in Figs. 12 to 17 illustrating further examples of embodiments of a backside coating prevention device described herein, each glass substrate 100 has a substrate front side 105 (also referred to herein as front side 105) to be coated and facing the sputtering cathodes 26 during transport of the glass substrate on the transport system 30. Hence, the front side 105 of each glass substrate 100 defines a substrate front plane 1200. The substrate front plane 1200 is shown in Fig. 12 as a dashed line. Furthermore, each glass substrate 100 has a backside 110 opposite to the front side 105 and facing the transport system 30 during transport of the glass substrate thereon. In addition, each glass substrate has two lateral ends 112, each comprising a lateral side 114. It is noted that Fig. 12 only shows one of the two lateral ends 112 of glass substrate 100. It will be understood by those skilled in the art that the arrangement shown in Fig. 12 is provided on the opposite lateral side of glass substrate 100 but in mirrored configuration.

In each of the examples and embodiments disclosed herein, the sputtering cathode 26 and, hence, the target thereof may extend over the lateral ends 112 of the glass substrate, in order to apply a coating of a uniform thickness, e.g. of a substantially constant thickness, onto the front side 105 of the substrate 100 over the whole area of the front side 105, i.e. even on the lateral ends 112. During transport of the glass substrates 100, two gaps 500 will be formed between the lateral sides 114 of the rectangular plate-shaped glass substrates 100 arranged on the transport system 30 and the sidewalls 17 of the compartment. These gaps 500 extend along the sidewalls 17 of the coating chamber 10 substantially in parallel to the transport direction. A number of ejected atoms of the target material may pass these gaps 500 and may undesirably be deposited on the backsides 110 of the glass substrates, typically due to scattering.

In view of the above, a backside coating prevention device according to embodiments described herein may optionally comprise two or more screens, the screens being provided at at least two of the walls of the coating chamber 10, each screen having a protruding member protruding from the respective wall, the screens being optionally provided above the substrate front plane. As is shown in Fig. 12, one example of such a backside coating prevention device may include two lateral screens 600, each sidewall 17 of the coating chamber 10 being provided with one of the screens 600 above the substrate front plane 1200.

Fig. 12 illustrates an enlarged cross-sectional view of one example of the screens 600 of the backside coating prevention device according to embodiments disclosed herein. It is noted that the proportions of the screen 600 and the glass substrate 100 as shown in Fig. 12 are not to scale. Each lateral screen 600 is typically made of stainless steel and typically has an L-shaped cross section, i.e. it comprises two branches 602 and 604 arranged substantially perpendicularly to each other. Branch 602 is attached to the interior surface of the sidewall 17 of the coating chamber 10. Branch 604 is provided at the bottom end of branch 602 and protrudes towards the centre of the coating chamber substantially in parallel to the substrate front plane 1200, i.e. substantially perpendicularly to the sidewall 17. Therefore, branch 604 forms the protruding member and extends along sidewall 17 substantially in parallel to the transport path 60. The installation height of branch 602 at the sidewall 17 in the coating chamber 10 is such that branch 604 is positioned about 1.5 to about 10 mm, typically about 1.5 to about 5 mm, most typically about 2 mm above the substrate front plane 1200. Both branches 602 and 604 of the lateral screens 600 further extend substantially in parallel to the substrate front plane 1200 along the sidewall 17 throughout the coating chamber 10, typically at least throughout a sputtering region of the coating chamber 10. That means that the sputtering cathode 26 forming the coating material source is adapted to dispense coating material at least into a coating region 70 of the coating chamber 10 and each screen 600 is provided at least in the coating region 70.

Typically, the material(s) of the screens of any example of embodiments disclosed herein is (are) vacuum-compatible and may be at least one element selected from the group consisting of Aluminum, an Aluminum alloy, or stainless steel in any of the embodiments described herein. However, other materials which are vacuum-compatible may be contemplated. The thickness of the screens or of the protruding member in any embodiment described herein, e.g. the thickness of any of the branches 602 and 604 in the present embodiment, may for example be a few mm, typically in the range from about 1 mm to about 10 mm, more typically from about 2 mm to about 5 mm. Moreover, in the embodiments described herein, typical dimensions of the protruding member, e.g. the dimensions of branch 604 in the present embodiment substantially in parallel to the transport direction, may be in the range from about 20 cm to about 100 cm. Furthermore, typical dimensions of the protruding member of any embodiment described herein, e.g. the dimensions of branch 604 of the present embodiment substantially perpendicular to the transport direction, may be in the range from about 10 cm to about 50 cm. That means that according to embodiments described herein, the dimensions of the protruding member of the screens may be LxW (Length x Width) = (10-50cm) x (20-100cm), wherein according to particular embodiments the Width W extends substantially in parallel to the transport direction.

In a typical embodiment, the protruding branch 604 is positioned to be about 1.5 mm to about 10 mm spaced apart from the one or more plate-shaped substrates 100 during coating. Furthermore, branch 604 protrudes from the sidewall 17 such that the branch 604 is positioned between the sputtering cathode 26 and the substrate front plane 1200. More specifically, as mentioned above, each glass substrate 100 supported on the substrate support plane has a front side 105 and lateral ends 112 each comprising a lateral side 114. As shown in Fig. 12, a gap 2100 is formed between the front side 105 of the glass substrate 100 and the lower side of branch 604, branch 604 being about 1.5 to about 10 mm, typically about 1.5 to about 5 mm, most typically about 2 mm spaced apart from the front side 105 of the glass substrate 100, depending on the installation height of branch 602 as explained above. Therefore, gap 2100 has a width of about 1.5 mm to about 10 mm, typically about 1.5 mm to about 5 mm, most typically about 2 mm. As a result of this small width, most of the Ag particles sputtered towards the gaps 500 between the glass substrate 100 and the sidewalls 17 are prevented from passing to the backside 110 thereof, since they are deposited on the upper surface of branches 604. The gap 2100 between protruding branch 604 and glass substrate 100 also allows for vibrations or sagging of the glass substrate 100 during transport, preventing contact or collisions of the glass substrate 100 with the protruding branches 604 of the backside coating prevention device.

In one variation according to embodiments described herein, the protruding member, e.g. formed as branch 604, has a lateral end protruding into the coating chamber, wherein the lateral end is positioned to be spaced apart from but substantially aligned with one of the lateral sides 114 of at least one of the one or more plate-shaped substrates 100 on the substrate support. In the screen 600 shown in Fig. 12, branch 604 has a lateral end formed as a front face 606. The lateral end of branch 604 is positioned above the substrate front plane 1200 and is spaced about 2 mm from the lateral side 114 of glass substrate 100 by gap 2100. Simultaneously, front face 606 of screen 600 is substantially aligned with the lateral side 114 of the glass substrate 100 supported on the transport system 30. Therefore, contact or collisions of the glass substrate 100 with the protruding branches 604 of the backside coating prevention device are avoided. Furthermore, Ag particles, which are sputtered towards the gaps 500 between the glass substrate 100 and the sidewalls 17, move along a straight trajectory and may also be deflected or scattered by collisions with other particles or with the sidewalls 17. Because of the alignment of front faces 606 of the protruding branches 604 with the lateral sides 114 of the glass substrate 100, most of the Ag particles, which are laterally sputtered towards the gaps 500 between the glass substrates 100 and the sidewalls 17, are adsorbed or deposited on the upper surfaces and the front faces 606 of the branches 604.

During coating operation, glass substrates 100, typically of substantially identical dimensions, are successively fed into the coating chamber 10 through the substrate feeding opening, continuously conveyed by the transport system 30 along the transport path 60 on the substrate support plane below the operating sputtering cathode 26, and discharged through the substrate discharge opening. Consequently, since the plate-shaped glass substrates have typically the same thicknesses, the front sides of the glass substrates define a common substrate front plane. Alternatively, in embodiments described herein, glass substrates of such varying dimensions or thicknesses may be successively fed into the coating chamber 10 that the protruding member of the backside coating prevention device is positioned to be spaced at least 1.5 mm from the one or more plate-shaped substrates during coating. That means in the present embodiment, that branch 604 is about 1.5 to about 10 mm, typically about 1.5 to about 5 mm, most typically about 2 mm spaced apart from the front side 105 of the glass substrates 100 having varying dimensions and, hence, from the substrate front planes 1200 defined thereby. Particles of Ag coating material are ejected from the sputtering cathode 26 towards the glass substrates 100 and also laterally towards the gaps 500 which are formed between the rectangular plate-shaped glass substrates 100 and the sidewalls 17 of the coating chamber 10. Coating particles ejected laterally towards these gaps 500 are mainly deposited on the upper surfaces of the protruding branches 604 of the screens 600. Thereby, passage of Ag particles through the gaps 500 between the glass substrates 100 and the sidewalls 17 towards the backsides 110 of the glass substrates 100 is reduced or substantially inhibited. Furthermore, coating of the lateral sides 114 of the substrates 100 is reduced or avoided. Moreover, the coating on the front sides of the glass substrates 100 is uniform even at the lateral ends 112 thereof, as is especially desired when glass substrates for solar cells are processed.

A further variation of embodiments is now described with reference to Fig. 13. Like in Fig. 12, a cross-sectional view of only one screen 700 of such a backside coating prevention device is shown. However, typically two lateral screens 700 are included in the backside coating prevention device. Each lateral screen 700 includes two branches 702 and 704 which are arranged as described with respect to the embodiment shown in Fig. 12. However, in the present embodiment the backside coating prevention device includes a protruding member having a lateral end being positioned to extend over a lateral part of the front side 105 of at least one of the one or more plate-shaped substrates 100 on the substrate support. Branch 704 differs from branch 604 shown in Fig. 12 in that the front face 706 of branch 704 is positioned above the glass substrate 100. That means that branch 704 extends over the lateral part 112 of the front side 105 of the glass substrate 100 during transport, i.e. it extends partially over the front side of the transport path 60. Thereby, backside coating of glass substrate 100 is prevented, even if an amount of the Ag particles laterally ejected from the sputtering cathode 26 is deflected or scattered by the sidewalls 17 or other particles towards the gap 2100 between the protruding branch 704 and the front side 105 of the glass substrate 100.

In the examples shown in Figs. 12 and 13, respectively, during sputtering an amount of particles of the sputtered Ag material, which are laterally ejected towards the sidewalls 17, is deposited on the surfaces of branches 602 and 702, respectively. As a result, in addition to the backside coating prevention effect of the screens 600 and 700, these embodiments reduce or inhibit contamination of the sidewalls 17 of the coating chamber 10 by Ag particles. Furthermore, maintenance of the coating chamber 10 may include a replacement of the lateral screens 600, 700 without the need for a sidewall cleaning procedure. In particular, the branches 602, 702 may cover sidewall 17 up to the top wall 14 of the chamber.

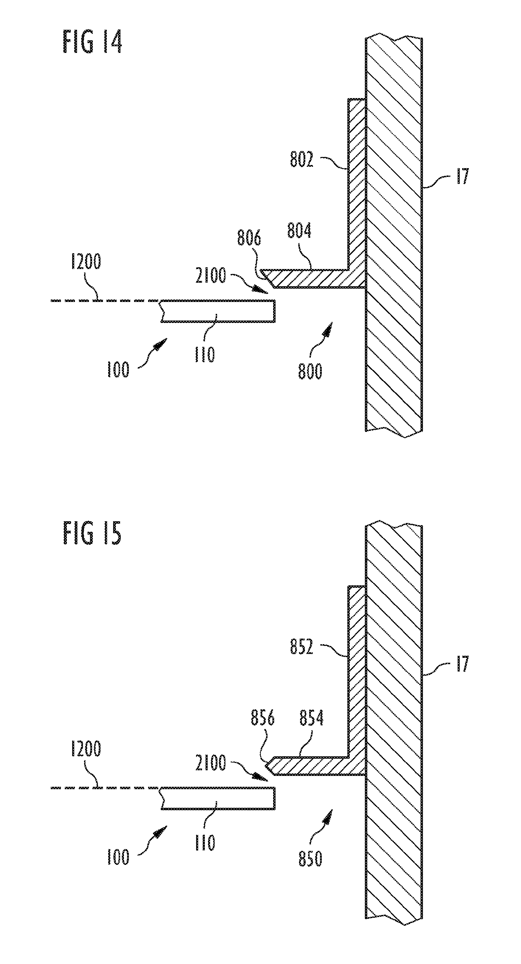

According to a further variation of embodiments described herein, said lateral end of the protruding member of the screen may be formed to taper away from the front side of a plate-shaped substrate 100 on the substrate support. In Figs. 14 and 15, respectively, examples of such a backside coating prevention device are shown, which correspond to the embodiment shown in Fig. 12 except for the design of the protruding lateral ends of the protruding branches. For instance, L-shaped screen 800 of Fig. 14 includes a branch 802 attached to the sidewall 17 and a branch 804 protruding above the substrate front plane 1200. The lateral end 806 of branch 804 has a wedge-shaped slanted face such that the protruding tip thereof is directed towards the top wall 14 of the coating chamber 10. Screen 850 shown in Fig. 15 has two branches 852 and 854. Branch 852 is attached to the sidewall 17 while branch 854 protrudes substantially in parallel to the substrate front plane 1200. In addition, the lateral end 856 of branch 854 has a tapered form such that the protruding central tip thereof is directed towards the opposing sidewall 17 of the coating chamber 10. In the examples of Figs. 14 and 15, since the protruding laterals ends 806 and 856 of the screens 600 and 650 are formed tapering away from the front side of the glass substrate 100, the clearance of the glass substrate 100 during transport is improved. Therefore, contact or collisions of the glass substrate 100 with the screens 800, 850 because of vibrations or sagging of the glass substrate 100 during transport can be avoided more safely while backside coating of the glass substrate is reduced or prevented. Simultaneously, a sufficient width of gap 2100 may be provided in the tapered portion of the protruding branches 804, 854 while the bottom surface of these branches 804, 854 is spaced from the substrate front plane 1200 less than the sufficient minimum gap width. Thus, the unwanted deposition of coating material on the backside of the glass substrate can be further reduced due to the very small gap width.

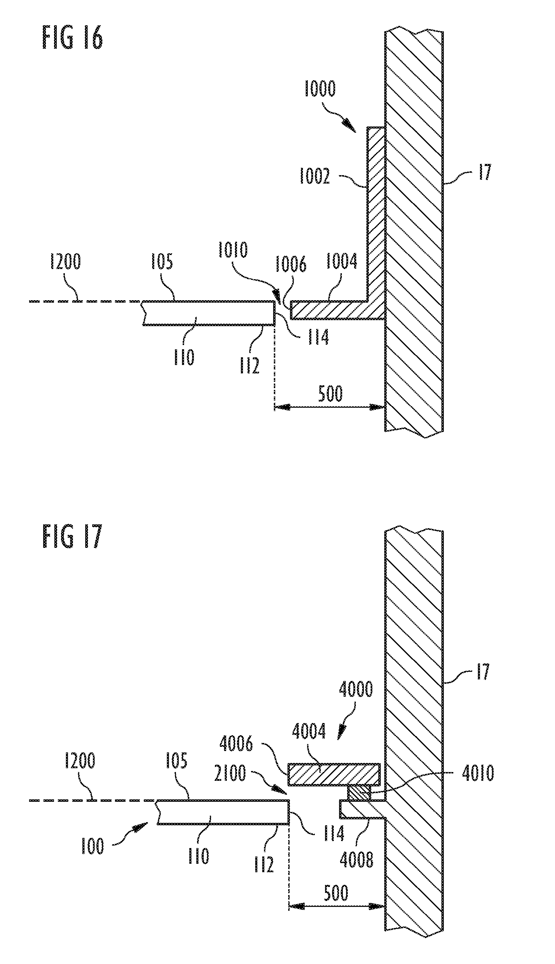

According to embodiments disclosed herein, the backside coating prevention device may have screens each comprising a protruding member being substantially aligned with the substrate. Furthermore, according to embodiments described herein, the backside coating prevention device may have screens each comprising a protruding member being substantially aligned with the substrate front plane 1200. An example of these embodiments is shown in Fig. 16.

According to Fig. 16, a screen 1000 comprises a branch 1002 attached to the sidewall 17 of the coating chamber 10 and a branch 1004 formed as a protruding member. Branch 1004 is mounted at the bottom end of branch 1002 and protrudes into the coating chamber 10. Branch 1004 has a lateral end 1006 facing the lateral side 114 of the glass substrate 100. The installation height of branch 1004 may be adjusted so that the upper side of branch 1004 is substantially aligned with the substrate front plane 1200, as shown in Fig. 16. Further in this example, screen 1000 is L-shaped, i.e. branches 1002 and 1004 are arranged substantially perpendicularly to each other. The length of branch 1004 is such that its lateral end 1006 is laterally spaced from the lateral side 114 of the glass substrate 100 by about 1.5 to about 10 mm, typically about 1.5 to about 5 mm, and most typically about 2 mm. As a result, only a small lateral gap 1010 having a width of about 1.5 to about 10 mm, typically about 1.5 to about 5 mm, and most typically about 2 mm is provided between branch 1004 and the lateral side 114 of the glass substrate 100. Through this gap 1010, only a negligible amount of Ag particles ejected from the sputtering cathodes 26 will pass.

Therefore, when using in a coating process a backside coating prevention device including two screens 1000 according to the example shown in Fig. 16, substantially all Ag coating particles travelling towards the gaps 500 between the glass substrate 100 and the sidewalls 17 are deposited on the upper surfaces of the protruding branches 1004. Hence, by providing screens 1000 on both sidewalls 17 of the coating chamber, passage of Ag particles through the gaps 500 between the glass substrates 100 and the sidewalls 17 towards the backside 110 of the glass substrate 100 is reduced or substantially inhibited.

Hence, according to embodiments disclosed herein, the protruding member may be substantially aligned with the substrate front plane. As shown in the example of Fig. 16, the installation height of branch 1004 may be adjusted so that the upper side of branch 1004 is substantially aligned with the substrate front plane 1200, resulting in a first position of the protruding member. In other examples, the installation height of branch 1004 shown in Fig. 16 may be adjusted so that the lower side of branch 1004 is substantially aligned with the substrate front plane 1200, resulting in a second position of the protruding member. Furthermore, the protruding member may be installed at any other position substantially aligning the protruding member with the substrate front plane. For example, the installation height of branch 1004 shown in Fig. 16 may be adjusted so that the protruding member is positioned between the first and the second position of the protruding member. Typically, the lateral end of the protruding member may be positioned on the substrate front plane. For instance, the upper part of the lateral end 1006 of the branch 1004 shown in Fig. 16 is positioned on the substrate front plane 1200. Alternatively, other parts of the lateral end 1006 may be positioned on the substrate front plane 1200.

Moreover, in embodiments disclosed herein, the protruding member may be positioned such that it is aligned with the substrate. Hence, the protruding member may have any position in which it is positioned opposite to, e.g. facing, a lateral side of a substrate supported on the substrate support. For instance, in a variation of the example shown in Fig. 16, branch 1004 may have any position in which the lateral end 1006 of the branch 1004 may face, at least partially, the lateral side 114 of the substrate 100.

In variations of the example shown in Fig. 16 and of other examples of embodiments described herein, the screens of the backside coating prevention device may each have a protruding branch arranged in an inclined way with an inclination different from 90 degrees with respect to the sidewall 17. Furthermore, for each screen the branch which is attached to the sidewall 17 may be mounted thereon at such an installation height, and the protruding branch may have such a length, that the lateral end of the protruding branch is positioned at least about 1.5 mm spaced apart from the lateral side 114 of the glass substrate 100. These modifications of the example illustrated in Fig. 16 will also result in a backside prevention effect as mentioned above for the example of Fig. 16.

Furthermore, according to embodiments described herein, the backside coating prevention device may have screens each comprising a protruding member comprising a panel and a holder, the holder being provided at a respective wall. The panel may be provided at the holder. The panel may be an elongated panel. The holder may be an elongated holder or may include a plurality of holder elements. The holder may be a protruding integral part of the respective wall. Alternatively, the holder may be a member provided at the respective wall.

Hence, as illustrated in Fig. 17 showing a cross-sectional view of one example of embodiments described herein, a screen 4000 may be an elongated panel 4004 mounted at its lower side at fixture 4010 of an elongated holder 4008 protruding from a sidewall 17. According to another example (not shown), the lower side of panel 4004 may be directly attached to the holder 4008, with no fixture or spacing between the lower side of the panel 4004 and the upper side of holder 4008. The panel 4004 may extend substantially in parallel to the transport path 60 and, hence, to the substrate front plane 1200. As illustrated in Fig. 17, the holder 4008 may be an elongated protrusion of the sidewall 17. Hence, it may be an integral part of the sidewall 17, as shown in Fig. 17. Alternatively, the holder 4008 may be an elongated member attached at the sidewall 17. According to the example shown in Fig. 17, the holder 4008 and the panel 4004 extend along the sidewall 17 in parallel to each other and in parallel to the transport path 60. Furthermore, in the present example, the dimensions of panel 4004 are such that a front side 4006 of the panel 4004 is substantially aligned with the lateral side 114 of the substrate 100. Typically, the holder 4008 may be provided at an installation height at sidewall 17 such that the lower side of panel 4004 is positioned spaced from and above glass substrate 100 during transport, such that the gap 2100 is formed between the panel 4004 and the substrate 100. The gap width of the gap 2100 between the bottom surface of the panel 4004 and the substrate front plane 1200 is in the range of about 1.5 mm to 5 mm, more typically about 2 mm. According to a specific design of the screen 4000 as shown in Fig. 17, the holder 4008 may be provided at the sidewall 17 in an installation height such that the upper side of the holder 4008 is substantially aligned with the front side 105 of the substrate and, at the same time, the gap 2100 is formed between the panel 4004 and the substrate 100. Each above mentioned design of the example shown in Fig. 17 results in a reliable reduction or prevention of a backside coating of glass substrate 100, because of the small width of the gaps 2100 between screen 4000 and the front side of glass substrate 100 in the range from about 1.5 to 5 mm, typically about 2 mm.

In a modification of the backside coating prevention device, in the above embodiments and examples described herein, respectively, the edges of the protruding members may have a rounded from, in order to avoid sharp edges which might damage the glass substrates 100 in case of vibrations or sagging during transport.

Furthermore, in each of the above embodiments and examples including screens, also one or more additional screens having a shape as described above in any of the embodiments and examples, respectively, may be provided at each sidewall 17 above and/or below the substrate front plane 1200, i. e. above and/or below the screens typically substantially in parallel thereto. Thereby, prevention of backside coating of the glass substrates 100 is promoted.

In addition, in further variations of the above embodiments and examples, respectively, the substrates 100 may be conveyed vertically instead of horizontally through the coating chamber. In such a case, as will be understood by the skilled person, the screens may be installed at other positions in the coating chamber, e.g. at the top and the bottom wall of the coating chamber, or may have correspondingly adapted modified profiles, in order to allow an installation at the sidewalls.

Moreover, in another modification of the above embodiments and examples, respectively, the coating chamber 10 may be a tube-shaped vessel having a tube-shaped wall closed by circular front and rear lids. The glass substrates 100 are transported in a direction parallel to the longitudinal axis of the tube-shaped vessel. Furthermore, the circular front and rear lids of this modification correspond to the front and rear walls as defined above. The sidewalls as defined above correspond to the areas of the tube-shaped wall facing the lateral ends 112 of the glass substrates 100 during transport.

A typical example of a material of the glass substrate 100, which may also be referred to as baseline substrate, is soda lime float glass and may have a standard or reduced iron content. In addition, in the embodiments described herein, a pre-coated glass substrate may be used. For example, the glass substrate 100 may be coated with a transparent conductive oxide. Further, the glass substrate 100 may have an amorphous and/or microcrystalline silicon p-in structure or an amorphous and/or microcrystalline silicon p-i-n-p-i-n tandem cell structure. Moreover, in case of coating a substrate for solar cells, substrates having a solar cell layer stack may be used in embodiments described herein. Furthermore, typical dimensions of glass plates used as glass substrate 100 according to embodiments described herein are in the range of about 1x1 sqm to about 3x6 sqm, typically about 2.2x2.6 sqm or about 1.1x1.3 sqm. Typically, the thickness of the glass substrate 100 according to embodiments described herein is in the range of about 2 mm to about 5 mm.

The written description uses examples to disclose the invention, including the best mode, and also to enable any person skilled in the art to make and use the invention. While the invention has been described in terms of various specific embodiments, those skilled in the art will recognize that the invention can be practiced with modifications within the spirit and scope of the claims. Especially, mutually non-exclusive features of the embodiments described above may be combined with each other. The patentable scope of the invention is defined by the claims, and may include other examples that occur to those skilled in the art. Such other examples are intended to be within the scope of the claims.

## Claims

1. A backside coating prevention device adapted for a coating chamber for coating plate-shaped substrates
said coating chamber being adapted for coating continuously or discontinuously transported plate-shaped substrates, comprising
a front wall having a substrate feeding opening and a rear wall having a substrate discharge opening,
a coating material source adapted for dispensing coating material into the coating chamber, and
a transport system, a front side of the transport system facing the coating material source, the transport system being adapted for continuously or discontinuously transporting a plurality of plate-shaped substrates along a transport path on the front side of the transport system,
wherein
said backside coating prevention device is adapted for providing a gas barrier at the front side of the transport system and adjacent to the backsides of the plurality of plate-shapes substrates for preventing backside coating of the plate-shaped substrates.

2. The backside coating prevention device according to claim 1, comprising a barrier gas supply unit adapted for dispensing a barrier gas at the front side of the transport system and adjacent to the backsides of the plurality of plate-shapes substrates.

3. The backside coating prevention device according to claim 2, wherein said barrier gas supply unit comprises
one or more barrier gas outlets provided in the front side of the transport system,
one or more barrier gas conduits connected to said one or more barrier gas outlets, and
a barrier gas source connected to said one or more barrier gas conduits.

4. The backside coating prevention device according to any of the preceding claims, further comprising a cover panel disposed at the front side of the transport system and below the backsides of the plurality of plate-shaped substrates, thus defining a space between the cover panel and the backsides of the plurality of plate-shaped substrates, wherein the coating prevention device is adapted for providing a gas barrier in the space defined between the cover panel and the backsides of said plurality of substrates.

5. A coating chamber for coating plate-shaped substrates,
said coating chamber being adapted for coating continuously or discontinuously transported plate-shaped substrates, comprising
a front wall having a substrate feeding opening and a rear wall having a substrate discharge opening,
a coating material source adapted for dispensing coating material into the coating chamber, and
a transport system, a front side of the transport system facing the coating material source, the transport system being adapted for continuously or discontinuously transporting a plurality of plate-shaped substrates along a transport path on the front side of the transport system,
wherein
said backside coating prevention device is adapted for providing a gas barrier at the front side of the transport system and adjacent to the backsides of the plurality of plate-shapes substrates for preventing backside coating of the plate-shaped substrates.

6. The coating chamber according to claim 5, wherein said backside coating prevention device comprises a barrier gas supply unit adapted for dispensing a barrier gas at the front side of the transport system and adjacent to the backsides of the plurality of plate-shapes substrates.

7. The coating chamber according to claim 6, wherein
said barrier gas supply unit comprises
one or more barrier gas outlets provided in the front side of the transport system,
one or more barrier gas conduits connected to said barrier gas outlets, and a barrier gas source connected to said one or more barrier gas conduits.

8. The coating chamber according to claim 7, wherein one or more of the barrier gas conduits are connected via one or more barrier gas valves to the barrier gas source, and wherein said barrier gas supply unit comprises a control means adapted for controlling the one or more barrier gas valves.

9. The coating chamber according to any of claims 6 to 8, wherein
one or more of said barrier gas outlets have the shape of a longitudinal slit formed in the front side of the transport system, the barrier gas outlets being arranged in parallel to each other and transverse to the transport path.

10. The coating chamber according to any of claims 6 to 9, wherein
one or more of said barrier gas outlets extend across the full width of the front side of the transport system.

11. The coating chamber according to any of claims 6 to 10, wherein the transport system comprises a plurality of rotatable rolls arranged successively from the front wall to the rear wall in parallel to each other, each roll having a plurality of spaced apart rings being each concentrically attached to the roll and supporting the glass substrates.

12. The coating chamber according to any of claims 6 to 11, the coating chamber being a vacuum coating chamber, and/or one or more of the openings in the front and rear walls of the vacuum coating chamber comprising a vacuum lock, an airlock or a slit valve or a combination thereof.

13. The coating chamber according to any of claims 6 to 12, wherein said coating material source dispenses coating material at least into a coating region of the coating chamber and each barrier gas outlet is provided at least in the coating region.

14. The coating chamber according to any of claims 6 to 13, wherein said coating chamber is adapted for coating by sputtering, the coating material source being one or more sputtering cathodes.

15. The coating chamber according to any of claims 6 to 14, wherein said backside coating prevention device further comprises at least two screens provided at two opposite sidewalls of the coating chamber, the sidewalls extending from the front wall to the rear wall of the coating chamber, each of the two sidewalls being provided with at least one of the screens, each screen having a protruding member protruding from the respective sidewall, each screen having the protruding member positioned so that each protruding member extends along the respective sidewall in parallel to the transport path and is spaced in the range from 1.5 mm to 5 mm from the plate-shaped substrates during coating.

16. The coating chamber according to any of claims 6 to 15, further comprising a cover panel disposed at the front side of the transport system and below the backsides of the plurality of plate-shaped substrates, thus defining a space between the cover panel and the backsides of the plurality of plate-shaped substrates, wherein the coating prevention device is adapted for providing a gas barrier in the space defined between the cover panel and the backsides of said plurality of substrates.

17. A method of coating plate-shaped substrates in a coating chamber, comprising
conveying a plurality of plate-shaped substrates through the coating chamber by
a) feeding one of the plate-shaped substrates into the coating chamber through a substrate feeding opening in a front wall of the coating chamber and arranging the plate-shaped substrate on a transport system for continuously or discontinuously transporting the plurality of plate-shaped substrates along a transport path on the front side of the transport system,
b) continuously or discontinuously transporting the plate-shaped substrate along the transport path, while providing a gas barrier at the front side of the transport system and adjacent to the backside of the plate-shaped substrate for preventing backside coating of the plate-shaped substrate and while dispensing coating material from a coating material source provided in the coating chamber towards a front side of the plate-shaped substrate,
c) discharging the plate-shaped substrate through a substrate discharge opening in a rear wall of the coating chamber, wherein the plate-shaped substrate is discharged while another one of the plate-shaped substrates is being conveyed through the coating chamber.

18. The method according to claim 17, wherein
two or more of the plate-shaped substrates are successively conveyed through the coating chamber,
gaps are formed between the two or more successively conveyed plate-shaped substrates, each gap being defined by two successively conveyed substrates and extending across the full width of the transport path,
the gas barrier is provided by supplying an amount of barrier gas at the front side of the transport system, the supplied amount of the barrier gas being controlled during steps a) to c).

19. The method according to claim 17 or18, wherein the gas barrier is provided by supplying an amount of a barrier gas from a barrier gas source through one or more barrier gas conduits and through one or more barrier gas outlets provided in the front side of the transport system.

20. The method according to claim 19, wherein the amount of said barrier gas supplied to one or more of the barrier gas outlets is controlled by a control means.

21. The method according to claim 19 or 20, wherein said barrier gas is supplied through the one or more of said barrier gas outlets, one or more of which having the shape of a longitudinal slit formed in the front side of the transport system and being arranged in parallel to each other and transverse to the transport path.

22. The method according to any of claims 19 to 21, wherein said barrier gas is supplied through the one or more of said barrier gas outlets, one or more of which extending across the full width of the front side of the transport system.

23. The method according to any of claims 19 to 22, wherein, when during steps a) to c) at least one of the barrier gas outlets is arranged near at least one of the gaps, the amount of barrier gas supplied to the at least one barrier gas outlet is reduced, while the amount of barrier gas supplied to other than the at least one barrier gas outlet is increased.

24. The method according to any of claims 17 to 23, wherein
one or more of the plate-shaped substrates is longer than the distance between the substrate feeding opening and the substrate discharge opening of the coating chamber, and
the amount of barrier gas supplied for providing the gas barrier is reduced when during conveying one of the transported plate-shaped substrates spans the distance between the substrate feeding opening and the substrate discharge opening, and is increased when during conveying one of the gaps between successively transported substrates is arranged inside the coating chamber.

25. The method according to any of claims 17 to 24, wherein during step b) backside coating of the plate-shaped substrates is further prevented by at least two screens provided at two opposite sidewalls of the coating chamber, the sidewalls extending from the front wall to the rear wall of the coating chamber, each of the two sidewalls being provided with at least one of the screens, each screen having a protruding member protruding from the respective sidewall, each screen having the protruding member positioned so that each protruding member extends along the respective sidewall in parallel to the transport path and is spaced in the range from 1.5 mm to 5 mm from the plate-shaped substrates during coating.
